# EUROPEAN PATENT APPLICATION

(11) **EP 1 855 335 A1**
(43) Date of publication of application: **14.11.2007**
(21) Application number: 06714047.5
(22) Date of filing: 14.02.2006
(51) Int. Cl.: H01M 4/88, H01M 4/96

(54) **METHOD AND APPARATUS FOR PRODUCING CATALYST LAYER FOR FUEL CELL**

(30) Priority: 14.02.2005 JP 2005036078
(71) Applicant: TOYOTA JIDOSHA KABUSHIKI KAISHA, Toyota-shi, Aichi-ken, 471-8571 (JP); Hori, Masaru, Nisshin-shi, Aichi 470-0117 (JP); Hiramatsu, Mineo, Aichi-gun, Aichi 4700162 (JP)
(72) Inventor: KANO, Hiroyuki, o, Nishikamo-gun, Aichi, 4700201 (JP); YOSHIDA, Satoshi, , Toyota-shi, Aichi, 4718571 (JP); KATAYAMA, Yukihisa, , Toyota-shi, Aichi, 4718571 (JP); SUGIYAMA, Toru, , Toyota-shi, Aichi, 4718571 (JP)
(74) Representative: Duckworth, Timothy John
(86) International application number: PCT/JP2006/302906
(87) International publication number: WO 2006/085694

(57) **Abstract**

A method for manufacturing a catalyst layer for a fuel cell support for a catalyst layer comprises the steps of vapor-growing a carbonaceous porous material having a nano-size structure, such as carbon nanowalls (CNWs), and supporting and dispersing a catalyst component and/or an electrolyte component on the support for a catalyst layer. The method simplifies the process for manufacturing an electrode layer for fuel cells and improves the dispersibility of the catalyst component and the electrolyte, whereby the generation efficiency of a fuel cell can be improved.

## Description

### TECHNICAL FIELD

The present invention relates to a catalyst layer for polymer electrolyte fuel cells which allows the simplification of manufacturing process, in which a uniform catalyst layer thin-film can be formed, and in which a sufficient three-phase interface can be formed. The invention also relates to a fuel cell employing such catalyst layer, and an apparatus for the manufacture of the catalyst layer for fuel cells.

### BACKGROUND ART

There are expectations that polymer electrolyte fuel cells having a polymer electrolyte membrane, which can be easily reduced in size and weight, will be put to practical applications as power supplies and the like for mobile vehicles, such as electric vehicles, and small-sized cogeneration systems. However, polymer electrolyte fuel cells have relatively low operating temperatures and their exhaust heat is not easily utilizable for effectively powering auxiliaries. As a result, their practical application requires performance such that high power generation efficiencies and high output-power densities can be obtained in an operating environment with high utilization ratios for an anode reaction gas (such as pure hydrogen) and a cathode reaction gas (such as air).

In a polymer electrolyte fuel cell, a membrane electrode assembly is used which has a structure such that an electrode catalyst layer having a fuel oxidizing capacity and an oxidant reducing capacity is disposed on both sides of the aforementioned ion-exchange membrane, and gas diffusion layers are further disposed on the outside of the catalyst layers. Specifically, the structure comprises an ion-exchange membrane consisting of a polymer electrolyte membrane for the selective transfer of hydrogen ion, on both sides of which electrode catalyst layers are formed which are primarily composed of carbon powder supporting a platinum-group metal catalyst. On the outer surfaces of the electrode catalyst layers, gas diffusion layers having both fuel gas permeability and electron conductivity are formed. Generally, a gas diffusion layer comprises a substrate of carbon paper or carbon cloth on which a membrane is formed of a paste containing a powder of fluorine resin, silicon, carbon or the like. The aforementioned electrode catalyst layers and the gas diffusion layers are referred to as electrodes.

The electrode reaction in each of the catalyst layers for the anode and cathode of the polymer electrolyte fuel cell proceeds at a three-phase interface (to be hereafter referred to as a reaction site) where the respective reaction gases, the catalyst, and the fluorine-containing ion exchange resin (electrolyte) exist simultaneously. Thus, in the polymer electrolyte fuel cell, a catalyst such as a metal catalyst or a metal-supported catalyst (such as a metal-supported carbon consisting of a carbon black support having a large specific surface area on which a metal catalyst such as platinum is supported) has conventionally been coated with a fluorine-containing ion exchange resin of a type which is the same as or different from the polymer electrolyte membrane, to provide the material for the catalyst layers, thereby achieving the so-called three-dimensionalization of the reaction site within the catalyst layers to increase the reaction site.

A typical example of the aforementioned fluorine-containing ion exchange resin with which the catalyst is coated is Nafion manufactured by DuPont, which is a perfluorocarbon polymer (to be hereafter referred to as sulfonic-acid type perfluorocarbon polymer) having a high ion conductivity and a sulfonate group, which is chemically stable in oxidizing and reducing atmospheres.

Currently, an electrode catalyst layer for fuel cells is fabricated through the steps of manufacturing carbon black, causing the carbon black to support a catalyst metal consisting primarily of a platinum group, impregnating the catalyst with a proton conductor, making the resultant electrolyte-platinum/carbon black in an ink form, and applying the ink to the electrolyte membrane. Thus, there are a large number of steps involved, and the dispersion of the proton conductor has not always been successful, resulting in the failure to sufficiently form a three-phase interface of the electrolyte, platinum, and support. As mentioned above, the three-phase interface refers to the interface of a proton conducting polymer, a catalyst metal, and a fuel gas ; the formation of such interface has a significant influence on power generation.

The problems of the conventional art are summarized below.
(1) Difficulty in obtaining a uniform thin-film of catalyst layer.
(2) Low productivity (i.e., the number of steps for catalyst layer synthesis is large).
(3) Increased cost due to the large number of production steps.
(4) Insufficient formation of the three-phase interface, resulting in the failure of the fuel gas to reach the interface and the inability to provide the full performance of the cell (i.e., the Pt utilization ratio is low).

These problems are believed to arise out of the following reasons.
(1) The application of the catalyst to the electrolyte requires the catalyst be in an ink form. It is difficult to obtain a uniform film thickness when applying the ink, resulting in uneven power generation. The compatibility of different materials makes the preparation of the ink difficult.
(2) The conventional catalyst layer manufacturing process requires multiple steps involving the causing of a manufactured support to support a catalyst component and then mixing an electrolyte solution, thus resulting in reduced productivity.
(3) The large number of steps increases the number or size of required facilities and thus increases cost.
(4) Since the conventional catalyst layer manufacturing process involves the supporting of catalyst metal and the subsequent impregnation of the electrolyte, the catalyst component is covered by the electrolyte, resulting in an insufficient formation of the three-phase interface, which is crucial for cell performance. Thus, there is the possibility of a decrease in cell performance.

Concerning a technology related to the catalyst layer, it is reported in Electrochem. Acta., vol. 38, No. 6, p. 793 (1993) that carbon fiber was used as a catalyst support, where a catalyst particle was supported on the surface of the carbon fiber. However, if a carbon fiber that supports a catalyst particle is fabricated and the fiber is formed on the surface of a current collector to form an electrode which is used in a fuel cell, although the probability of the electrons generated near the electrolyte membrane moving between the particles (fibers) before they arrive at the current collector may become smaller, several times of transfers between the particles would be normally required, which will make it difficult to increase the electron conductivity sufficiently.

Thus, it has been difficult with the conventional electrodes for fuel cells to increase the electric conductivity of the catalyst layer to sufficient levels, and so it has been impossible to achieve a sufficiently high fuel cell generation efficiency. JP Patent Publication (Kokai) No. 2002-298861 A discloses an invention of an electrode for fuel cells, its object being the provision of a fuel cell having a high generation efficiency, a fuel cell electrode for realizing such fuel cell, and a method for manufacturing a fuel cell electrode achieving such fuel cell. This electrode comprises a current collector made of a conductive porous material, and a catalyst layer comprised of carbon nanofiber of which 50% or more of the tip portions has an angle of elevation of 45° or more with respect to the plane of the current collector, an electrode catalyst particle supported on the carbon nanofiber surface, and a proton conductor formed on the surface of the carbon nanofiber in contact with the electrode catalyst particle.

### DISCLOSURE OF THE INVENTION

The above invention disclosed in JP Patent Publication (Kokai) No. 2002-298861 A makes it possible to simplify the process of manufacturing an electrode for fuel cells that is comprised of an electrode catalyst layer and a gas diffusion layer, and to improve the conductivity of the catalyst layer, whereby the fuel cell generation efficiency can be increased to some extent. However, the extent of improvement was not sufficient.

Thus, in view of the problems of the conventional art, it is an object of the invention to simplify the manufacturing process for an electrode for fuel cells consisting of an electrode catalyst layer and a gas diffusion layer and to enable a sufficient formation of the three-phase interface, so that an increased fuel cell generation efficiency can be obtained.

The present invention is based on the inventors' realization that the above problems can be solved by using a specific carbonaceous porous material having a vapor-grown nano-size structure for the diffusion layer and/or the catalyst layer of the electrode for fuel cells, and particularly by carrying out the supporting and dispersion of a catalyst component and/or an electrolyte in the same chamber.

In one aspect, the invention provides a method for manufacturing a catalyst layer for a fuel cell. The method comprises the steps of: vapor-growing a carbonaceous porous material having a nano-size structure, such as a carbon nanowall (CNW), as a support for a catalyst layer; and supporting and dispersing a catalyst component and/or an electrolyte component on the support for a catalyst layer. Carbon nanowall (CNW) is a carbonaceous porous material having a nano-size structure. Its structure, method of manufacture, and so on are described later. The catalyst and the polymer electrolyte used in the present invention may be those widely known.

The above method makes it possible to greatly simplify the manufacturing process compared with conventional fuel cell structure manufacturing methods. The method also enables a sufficient formation of the three-phase interface. Furthermore, since the carbonaceous porous material having a nano-size structure, such as carbon nanowall (CNW), has a large specific surface area, the amount of platinum-group precious-metal catalyst that is used can be reduced.

Preferably, the individual steps of the method for manufacturing a catalyst layer for a fuel cell according to the invention are carried out in the same chamber. Specifically, for example:
(a) In the same chamber, the step (1) of vapor-growing a carbonaceous porous material having a nano-size structure as a support for a catalyst layer is carried out, and then the step (2) of supporting and dispersing a catalyst component on the support for a catalyst layer, and the step (3) of causing an electrolyte component to become supported and dispersed on the support for a catalyst layer are carried out simultaneously.
(b) In the same chamber, the step (1) of vapor-growing a carbonaceous porous material having a nano-size structure as a support for a catalyst layer, then the step (2) of supporting and dispersing a catalyst component on the support for a catalyst layer is carried out, followed by the step (3) of causing an electrolyte component to become supported and dispersed on the support for a catalyst layer.
(c) In the same chamber, the step (1) of vapor-growing a carbonaceous porous material having a nano-size structure as a support for a catalyst layer is carried out, then the step (3) of causing an electrolyte component to become supported and dispersed on the support for a catalyst layer is carried out, followed by the step (2) of supporting and dispersing a catalyst component on the support for a catalyst layer is carried out.
(d) In the same chamber, the step (1) of vapor-growing a carbonaceous porous material having a nano-size structure as a support for a catalyst layer, the step (2) of supporting and dispersing a catalyst component on the support for a catalyst layer, and the step (3) of causing an electrolyte component to become supported and dispersed on the support for a catalyst layer are all carried out simultaneously.

Preferably, the step (2) of causing the catalyst component to become supported and dispersed on the support for a catalyst layer and/or the step (3) of causing the electrolyte component to become supported and dispersed on the support for a catalyst layer are carried out by one or more methods selected from the laser abrasion method, plasma discharge method, arc discharge method, and a method by which a gas or solution containing a catalyst and/or an electrolyte is supported and dispersed on the support.

In a second aspect, the invention provides a fuel cell comprising the catalyst layer for fuel cell manufactured by the above method. The fuel cell having the fuel cell structure of the invention may be either planar or cylindrical.

In a third aspect, the invention provides an apparatus for producing the above catalyst layer for fuel cell. The apparatus comprises, in the same chamber: a plasma generating apparatus for vapor-growing a carbonaceous porous material having a nano-size structure as a support for a catalyst layer, such as carbon nanowall (CNW); and one or more kinds of generating apparatus for causing a catalyst component and/or electrolyte component to become supported and dispersed on the support for a catalyst layer, the one or more kinds of generating apparatus being selected from a laser abrasion apparatus, plasma discharge apparatus, and arc discharge apparatus.

The carbonaceous porous material having a nano-size structure includes graphite and amorphous; examples are fullerene, carbon nanotube, carbon nanohorn, and carbon nanoflake, of which carbon nanowall is particularly preferable in the present invention.

The carbon nanowall used in the present invention is a two-dimensional carbon nanostructure. It typically has a wall-like structure in which walls rise from the surface of the substrate in a substantially uniform direction. Fullerene (such as C60) is a zero-dimensional carbon nanostructure. Carbon nanotube can be considered to be a one-dimensional carbon nanostructure. Carbon nanoflake is an aggregate of planar, two-dimensional small pieces similar to carbon nanowalls; like the petals of the rose, the individual pieces are not mutually connected; it is a carbon nanostructure whose directionality with respect to the substrate is inferior to the carbon nanowall. Thus, the carbon nanowall is a carbon nanostructure having totally different characteristics from the fullerene, carbon nanotube, carbon nanohorn, or carbon nanoflake.

By using a carbonaceous porous material having a nano-size structure such as carbon nanowall, which is a carbon nanomaterial having a nanostructure whose microscopic structure such as porosity, and whose macroscopic structure, such as pattern, can be freely changed, as the catalyst support in the catalyst layer for fuel cell, (1) manufacturing process can be greatly simplified, resulting in a reduction in manufacturing cost; and (2) a uniform catalyst layer thin-film can be formed, allowing the formation of a sufficient three-phase interface. As a result, improved fuel cell performance can be obtained.

### BRIEF DESCRIPTION OF THE DRAWINGS

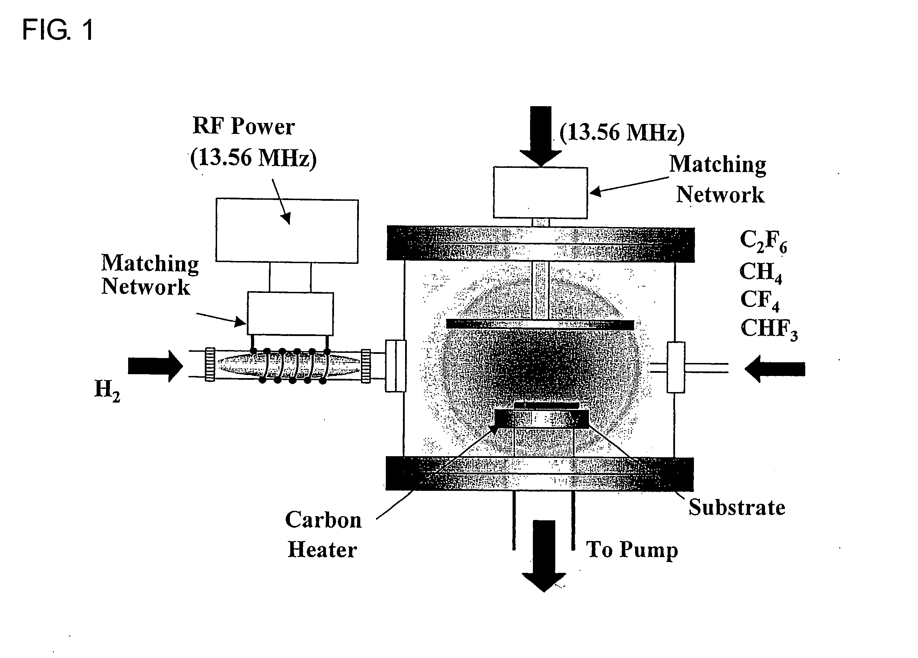

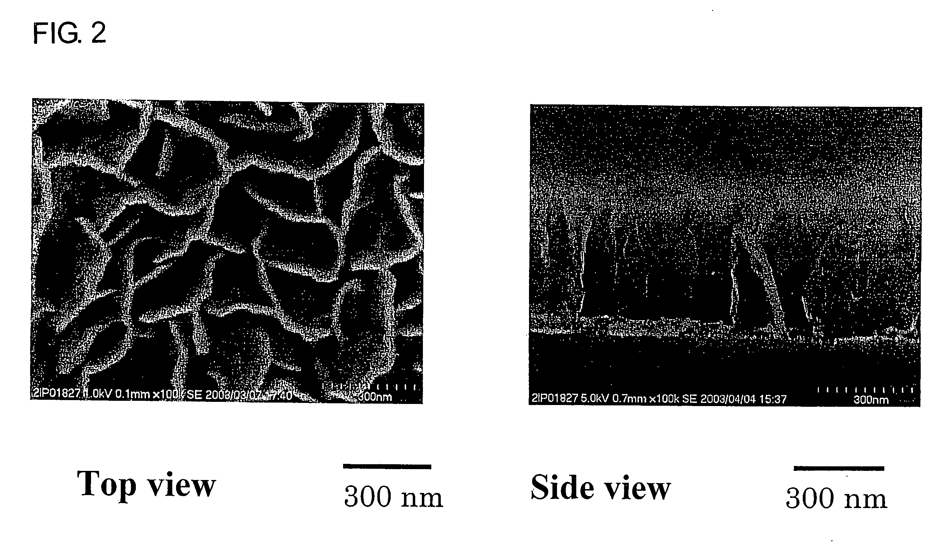

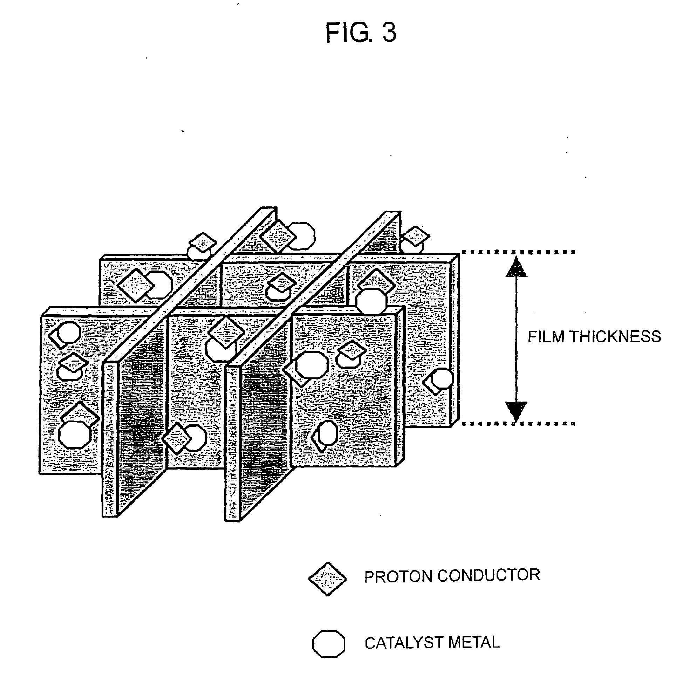

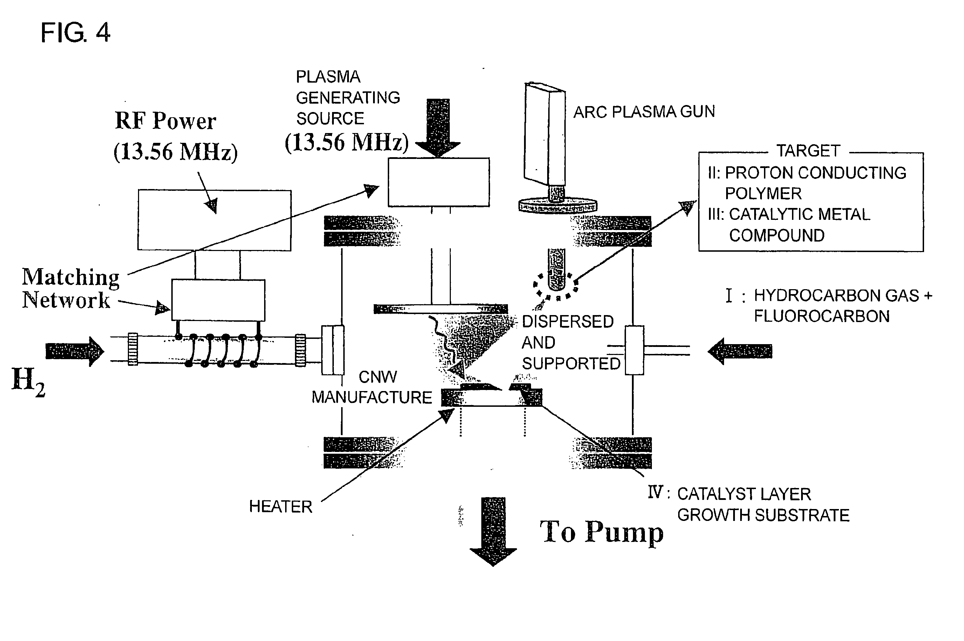

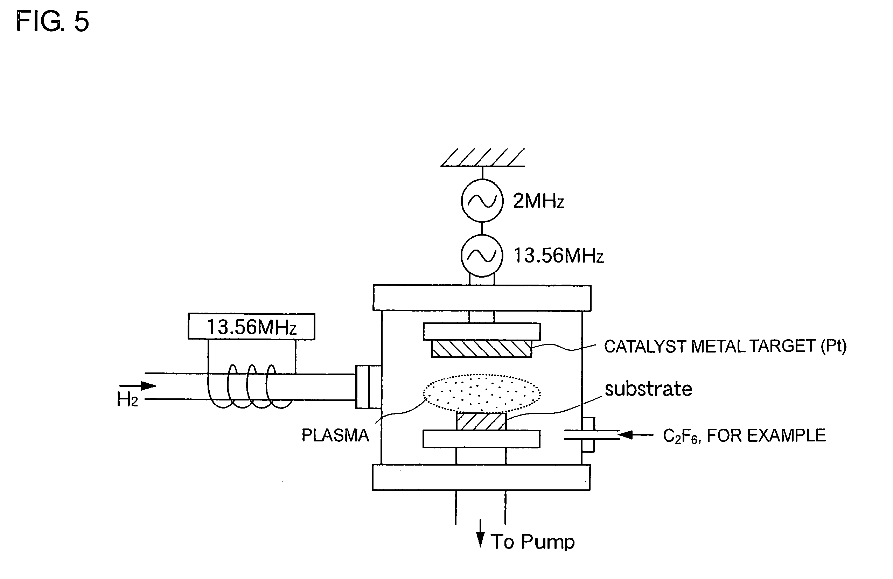

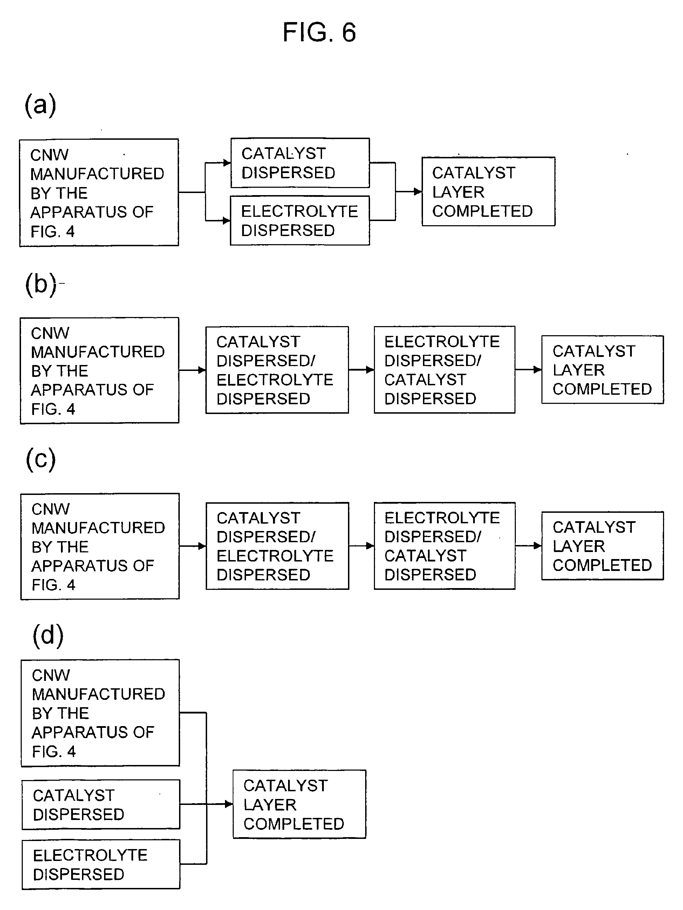

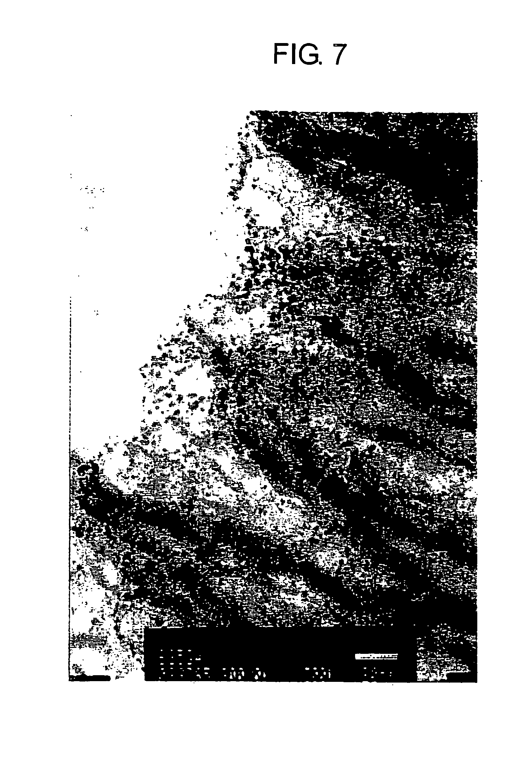

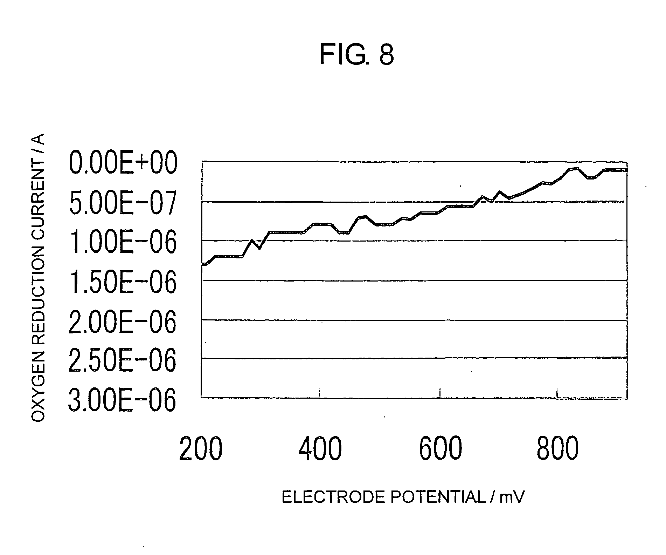

Fig. 1 schematically shows an apparatus for the manufacture of CNW. Fig. 2 shows SEM images of fabricated CNW. Fig. 3 schematically shows a carbon nanowall (CNW) catalyst layer in which a catalyst metal and a proton conductor, which is an electrolyte, is supported and dispersed according to the invention. Fig. 4 schematically shows a structure of a catalyst layer one-step manufacturing apparatus used in the invention. Fig. 5 shows schematically another structure of the catalyst layer one-step manufacturing apparatus used in the invention. Figs. 6(a) to 6(d) shows flowcharts illustrating the order of formation of layers in accordance with the invention. Fig. 7 shows an SEM image of a prepared sample. Fig. 8 shows the result of evaluation of catalyst activity of the prepared sample by the RDE method.

### BEST MODE OF CARRYING OUT THE INVENTION

A process for manufacturing carbon nanowall (CNW), which is most suitable as a carbonaceous porous material having a nano-size structure, is described below.

Fig. 1 schematically shows an apparatus for manufacturing CNW. Fig. 2 shows SEM images of CNW fabricated using the apparatus. With reference to Fig. 1, an H radical and a reaction gas containing carbon, such as CF₄, C₂F₆, or CH₄, are introduced between parallel plate electrodes in the chamber, and PECVD (plasma-enhanced chemical vapor deposition) is conducted. At this time, the substrate is preferably heated to about 500°C. The parallel plate electrodes are spaced apart from each other by 5 cm; between the plates, a capacitively coupled plasma is produced using an RF output apparatus of 13.56MHz with an output of 100W. The site of H radical growth is a quartz tube with length 200 mm and internal diameter φ 26 mm, into which H₂ gas is introduced to produce an inductively coupled plasma using the RF output apparatus of 13.56MHz with output 400W. The flow rates of the source gas and the H₂ gas are 15 sccm and 30 sccm, respectively, and the pressure inside the chamber is 100 mTorr. The height of the CNW (CNW film thickness) grown in this system for 8 hours is 1.4 µ m; this, however, is merely an example, and these passages do not limit the experiment conditions, facility, or results.

In the following, the present invention is described with reference to the drawings.

Fig. 3 schematically shows a carbon nanowall (CNW) catalyst layer according to the invention in which a catalyst metal and a proton conductor, which is an electrolyte, are supported and dispersed. A solid polymer membrane that is not shown is sandwiched by the solid polymer film catalyst layers of Fig. 3. In the example of Fig. 3, the catalyst support is formed of carbon nanowall (CNW), wherein the side walls of the carbon nanowall (CNW) catalyst support have the catalyst metal and the proton conductor supported and dispersed therein.

In the following, the invention is described with reference to examples; the invention, however, is not limited by any of the examples.

### [Example 1]

A process of manufacturing a catalyst layer thin-film using the catalyst layer one-step manufacturing apparatus shown in Fig. 4 is described. In the present Example, CNW is used as the diffusion layer support. Within the same chamber, the support (CNW) is manufactured and, at the same time, a catalyst component and an electrolyte (proton conducting material) are supported and dispersed on the support using a laser or plasma to manufacture the catalyst layer. For the supporting/dispersion of the catalyst component and the electrolyte (proton conducting material), a laser abrasion method, plasma method, or arc discharge method may be used, for example. In the present example, the catalyst component and the electrolyte may be dispersed either sequentially or simultaneously.

The source gas consists of a mixture of hydrocarbon and halogen-containing hydrocarbon. The proton conductor consists of a substance having a sulfonate group, phosphonate group, hydroxyl group, imidazole group, solid acid salt, tropolone, ionic liquid, or the like as a proton carrier. The catalyst material consists of a group-8 metal, Cu, Ag, Au, or Ce; an organic metal compound of two or more of such substances; a metal salt or a metal of such substances; or a mixture thereof. These catalyst materials are merely examples, and other catalyst materials known in the art of fuel cell may be used. The substrate may be formed of a polymer material, a metal, carbon, or ceramics, or a compound of two or more of such materials. After growth, the thin-film catalyst layer that is grown can be easily peeled.

In the following, examples of the use of a laser abrasion method, plasma discharge method, and arc discharge method for the supporting and dispersion of the catalyst component and the electrolyte (proton conducting material) are described.

### Laser Abrasion Method

### (Catalyst metal)

After fabrication of CNW, the chamber is substituted with Ar gas and is then evacuated with a vacuum pump to set the pressure at 0.1 to 1 mTorr. The substitution gas may be some other inactive gas, such as He or N₂, for example. The laser with which the chamber is internally irradiated consists of a KrF excimer laser (wavelength 248 nm). A Pt metal target is set vertically toward the CNW sample and is then irradiated with the excimer laser having a pulse energy of 100 to 400 mJ/pulse, irradiated area of 0.05 cm² (i.e., energy density of 2 to 8 J/cm²), and frequency of 100 Hz, for 1 min, thereby abrasing the Pt metal and causing fine particles of the catalyst metal (Pt) to be supported on the CNW. At this time, the weight of Pt supported on the CNW is approximately 0.025 to 0.1 mg/cm²- CNW substrate, and the diameter of the Pt particle is approximately 3 nm. The amount of Pt that is supported can be controlled in proportion substantially to the frequency and the irradiation duration of time. Besides the KrF excimer laser, other lasers may be used, such as various excimer lasers such as ArF, XeCl, and XeF lasers, YAG laser, and CO₂ laser, for example.

### (Proton conductor)

After CNW is supported on the catalyst metal, the same KrF excimer laser is used to irradiate a proton conductor ("Nafion" manufactured by DuPont) that is set vertically in the direction of the CNW sample, the laser having a pulse energy of 40 to 400 mJ/pulse, irradiated area of 0.4 cm² (i.e., energy density of 0.1 to I J/cm²), and frequency of 100Hz, for 1 min, thereby abrasing the proton conductor and causing the proton conductor to be supported on the Pt-supported CNW. At this time, the chamber pressure is 0.1 to 1 mTorr; the atmosphere gas may be another inactive gas such as He or N₂, besides Ar. The weight of the proton conductor supported on the CNW is approximately 0.025 to 0.1 mg/cm²- CNW substrate. The amount of the proton conductor that is supported can be controlled in proportion substantially to the frequency and the irradiation duration of time. Besides the KrF excimer laser, other lasers may be used, such as various excimer lasers such as ArF, XeCl, and XeF lasers, and F2 laser, for example.

### Plasma Discharge Method

### (Catalyst metal)

After fabrication of CNW, the chamber is substituted with Ar gas and is then evacuated using a vacuum pump to set the pressure at 50 to 500 mTorr. The Ar gas used is passed through an organic solvent (such as hexane) beforehand in which a platinum organic material (such as trimethylmethylcyclopentadienyl platinum, for example) is dissolved. The substitution gas may alternatively be another inactive gas such as He or N₂. Using the RF output apparatus of 13.56MHz and 100W, a capacitively coupled plasma is produced. When the duration of time of plasma generation is 1 minute, the amount of Pt that is supported is approximately 0.05 mg/cm². The amount of Pt supported can be controlled in proportion substantially to the duration of plasma generation.

### (Proton conductor)

After the CNW is supported on the catalyst metal, the chamber is substituted with Ar gas and is then evacuated using a vacuum pump to set the pressure at 50 to 500 mTorr. The Ar gas is passed through an organic solvent (such as ethanol) beforehand in which a proton conductor ("Nafion" manufactured by DuPont. The type of lower molecular weight is preferable.) is dissolved. The substitution gas may alternatively be another inactive gas, such as He or N₂. Using the RF output apparatus of 13.56 MHz and 100W, a capacitively coupled plasma is produced. When the time of duration of plasma generation is 1 minute, the amount of the proton conductor that is supported is approximately 0.05 mg/cm². The amount of the proton conductor that is supported can be controlled in proportion substantially to the duration of plasma generation.

### Arc Method

### (Catalyst metal)

After fabrication of CNW, the chamber is substituted with Ar gas and is then evacuated using a vacuum pump to set the pressure at 0.1 to 1 mTorr. The substitution gas may alternatively be other inactive gases such as He or N₂. A Pt metal target is set on an arc plasma gun (manufactured by ULVAC, Inc.) installed in the chamber in the direction of a CNW sample. A voltage is applied to the trigger electrode so as to evaporate the target and cause the Pt particles to be supported on the CNW. The arc voltage is 60V; pulse width is 1 sec; and the number of times of applying the pulse is 200. In this case, the amount of Pt supported is approximately 0.1 mg/cm². The amount of Pt supported can be controlled in proportion substantially to the number of times of application of the pulse.

### (Proton conductor)

After the catalyst metal is supported on the CNW, the chamber is substituted with Ar gas and is then evacuated using a vacuum pump to set the pressure at 0.1 to 1 mTorr. The substitution gas may alternatively be other inactive gases such as He and N₂, for example. A proton conductor ("Nafion" manufactured by DuPont) target is set on the arc plasma gun (manufactured by ULVAC, Inc.) installed in the chamber in the direction of the CNW sample. A voltage is applied to the trigger electrode to evaporate the target so as to cause the proton conductor to be supported on the CNW. The arc voltage is 60V; pulse width is 1 sec; and the number of times of application of the pulse is 200. In this case, the amount of proton conductor that is supported is approximately 0.1 mg/cm². The amount of proton conductor that is supported can be controlled in proportion substantially to the number of times of application of the pulse.

### [Example 2]

In the following, a process for manufacturing a catalyst layer thin-film using another catalyst layer one-step manufacturing apparatus shown in Fig. 5 is described. In this example, in addition to the high-frequency for the generation of plasma, a lower high-frequency is applied to the same electrode. In this way, by placing a catalyst metal, such as platinum, on the surface of the electrode in advance, the metal nanoparticles jump out into the plasma by plasma sputtering and become supported on the surface of the CNW. It is also possible to supply a gas or a solution containing the catalyst metal into the plasma so as to causes the catalyst metal to be supported on the CNW. In this case, the method of supply may involve a nozzle or the like.

Examples 1 and 2 provide the following effects:
(1) The use of CNW eliminates the need of film formation in a subsequent process step. The one-step manufacture makes it possible to achieve reduction in cost and the size of equipment.
(2) The catalyst component and the electrolyte can be highly dispersed. The amount of electrolyte that is mixed can also be easily controlled, so that the problem of the electrolyte covering a platinum-group catalyst to result in a decrease in the activity of the platinum-group catalyst, for example, can be prevented. The amount of platinum-group catalyst that is used can be reduced, so that cost can also be reduced.

Fig. 6 shows flowcharts of examples of the sequence of film formation according to the invention. Fig. 6(a) shows a flow in a case where, in the same chamber: (1) carbon nanowall (CNW) is vapor-grown as the support for a catalyst layer; and then, (2) the catalyst component is supported and dispersed on the support for a catalyst layer and, simultaneously, (3) the electrolyte component is supported and dispersed on the support for a catalyst layer. Fig. 6(b) shows a case where, in the same chamber: (1) carbon nanowall (CNW) is vapor-grown as the support for a catalyst layer; then, (2) the catalyst component is supported and dispersed on the support for a catalyst layer; and then (3) the electrolyte component is supported and dispersed on the support for a catalyst layer. Fig. 6(c) shows a case where, in the same chamber: (1) carbon nanowall (CNW) is vapor-grown as the support for a catalyst layer; then, (3) the electrolyte component is supported and dispersed on the support for a catalyst layer; and then (2) the catalyst component is supported and dispersed on the support for a catalyst layer. Fig. 6(d) shows a case where, in the same chamber: (1) the vapor-growth of carbon nanowall (CNW) as the support for a catalyst layer; (2) the supporting and dispersion of the catalyst component on the support for a catalyst layer; and (3) the supporting and dispersion of the electrolyte component on the support for a catalyst layer are all carried out simultaneously.

### Evaluation of Performance

Data concerning the catalytic ability of Pt supported on CNW manufactured using the catalyst layer one-step manufacturing apparatus shown in Fig. 4 is described. Using the apparatus of Fig. 4, Pt was supported on CNW by arc discharge. The arc voltage was 60V (maximum:100V); the pulse width was 1 sec; and the number of times of discharge was 100.

Fig. 7 shows an SEM image of the prepared sample. The black dots in Fig. 7 represent Pt, which are clearly seen to be finely and highly dispersed.

Fig. 8 shows the result of evaluation of catalyst activity of the above prepared sample according to the RDE method. The graph shows that more oxygen reduction current flows as the voltage decreases. This indicates that the prepared sample has the catalytic function of reducing oxygen and can be used as an electrode catalyst for fuel cells.

### INDUSTRIAL APPLICABILITY

In accordance with the invention, a carbonaceous porous material having a nano-size structure, such as carbon nanowall, is used as the support in the catalyst layer for fuel cells, whereby a catalyst layer in which a catalyst component and an electrolyte are highly dispersed can be formed. Thus: (1) it becomes possible to manufacture an integrated catalyst layer by a vapor-phase reaction in a series of operations, so that the fuel cell manufacturing process can be greatly simplified and manufacturing cost can be reduced; and (2) a uniform catalyst layer thin-film can be formed, and a sufficient three-phase interface can be formed, whereby improved fuel cell performance can be obtained. Thus, the invention contributes to the wide-spread use of fuel cell.

## Claims

1. A method for manufacturing a catalyst layer for a fuel cell, the method comprising the steps of:
vapor-growing a carbonaceous porous material having a nano-size structure as a support for a catalyst layer; and
supporting and dispersing a catalyst component and/or an electrolyte component on the support for a catalyst layer.

2. The method for manufacturing a catalyst layer for a fuel cell according to claim 1, wherein the carbonaceous porous material having a nano-size structure comprises carbon nanowall (CNW).

3. The method for manufacturing a catalyst layer for a fuel cell according to claim 1 or 2, comprising the steps of:
(1) vapor-growing a carbonaceous porous material having a nano-size structure as a support for a catalyst layer;
(2) supporting and dispersing a catalyst component on the support for a catalyst layer; and
(3) simultaneously causing an electrolyte component to become supported and dispersed on the support for a catalyst layer, wherein the steps (2) and (3) are performed simultaneously in the same chamber.

4. The method for manufacturing a catalyst layer for a fuel cell according to claim 1 or 2, comprising the steps of:
(1) vapor-growing a carbonaceous porous material having a nano-size structure as a support for a catalyst layer;
(2) then supporting and dispersing a catalyst component on the support for a catalyst layer; and
(3) then causing an electrolyte component to become supported and dispersed on the support for a catalyst layer, which steps are performed in the same chamber.

5. The method for manufacturing a catalyst layer for a fuel cell according to claim 1 or 2, comprising the steps of:
(1) vapor-growing a carbonaceous porous material having a nano-size structure as a support for a catalyst layer;
(3) then causing an electrolyte component to become supported and dispersed on the support for a catalyst layer; and
(2) then supporting and dispersing a catalyst component on the support for a catalyst layer, which steps are carried out in the same chamber.

6. The method for manufacturing a catalyst layer for a fuel cell according to claim 1 or 2, comprising the steps of (1) vapor-growing a carbonaceous porous material having a nano-size structure as a support for a catalyst layer;
(2) supporting and dispersing a catalyst component on the support for a catalyst layer; and
(3) causing an electrolyte component to become supported and dispersed on the support for a catalyst layer, wherein the above steps are performed all simultaneously in the same chamber.

7. The method for manufacturing a catalyst layer for a fuel cell according to any one of claims 1 to 6, wherein the step (2) of supporting and dispersing a catalyst component on the support for a catalyst layer and/or the step (3) of causing an electrolyte component to become supported and dispersed on the support for a catalyst layer are carried out by one or more methods selected from the laser abrasion method, plasma discharge method, arc discharge method, and a method by which a gas or solution containing a catalyst and/or an electrolyte is supported and dispersed on the support.

8. A fuel cell including a catalyst layer for a fuel cell manufactured by the method of any one of claims 1 to 7.

9. An apparatus for manufacturing a catalyst layer for a fuel cell, the apparatus comprising, in the same chamber:
a plasma generating apparatus for vapor-growing a carbonaceous porous material having a nano-size structure as a support for a catalyst layer; and
one or more generating apparatuses selected from a laser abrasion apparatus, plasma discharge apparatus, and arc discharge apparatus.

10. The apparatus for manufacturing a catalyst layer for a fuel cell according to claim 9, wherein the carbonaceous porous material having a nano-size structure comprises carbon nanowall (CNW).
